# EUROPÄISCHE PATENTSCHRIFT

(11) **EP 1 182 917 B1**
(45) Veröffentlichungstag und Bekanntmachung des Hinweises auf die Patenterteilung: **09.11.2005**
(21) Anmeldenummer: 01118404.1
(22) Anmeldetag: 31.07.2001
(51) Int. Cl.: H05K 9/00, H01R 13/658, H05K 5/00

(54) **Vorrichtung zur Abschirmung**
Shielding device
Dispositif de blindage électromagnétique

(30) Priorität: 17.08.2000 DE 10040215
(43) Veröffentlichungstag der Anmeldung: 27.02.2002
(73) Patentinhaber: SIEMENS AKTIENGESELLSCHAFT, 80333 München (DE)
(72) Erfinder: Sievers, Christopher, 63450 Hanau (DE); Berberich, Reinhold, 60439 Frankfurt (DE)

(56) Entgegenhaltungen:
- DE-A- 19 803 358
- DE-A- 19 848 732
- US-A- 6 045 411

## Beschreibung

Die Erfindung betrifft eine Vorrichtung zur Abschirmung einer auf einer Leiterplatte befindlichen elektronischen Schaltung in einem elektrisch leitenden Gehäuse, das mindestens eine Öffnung und/oder Durchführung aufweist.

Bei elektronischen Geräten können aufgrund elektromagnetischer Strahlung externer Quellen Störungen und Fehler auftreten. Besondere Schwachstellen sind hierbei die Durchführungen von Anschlussstiften durch das die elektronische Schaltung umgebende elektrisch leitende Gehäuse, sowie die Anschlussstifte selbst.

Aufgabe der vorliegenden Erfindung ist es daher, die Abschirmung im Bereich von Öffnungen und Durchführungen des Gehäuses zu verbessern.

Diese Aufgabe wird bei einer ersten Ausführungsform der Erfindung dadurch gelöst, dass sich ein Abschirmrohr von der Leiterplatte bis zum Gehäuse erstreckt und die Öffnung und/oder die Durchführung umfasst und dass eine Einrichtung zum Längenausgleich des Abschirmrohres einen elektrischen Kontakt des Abschirmrohres unabhängig von Toleranzen zwischen der Leiterplatte und des Gehäuses dadurch bildet, dass das Abschirmrohr in Längsrichtung federnd ist. Vorzugsweise ist mindestens ein Teil des Abschirmrohres balgförmig.

Die erfindungsgemäße Vorrichtung hat den Vorteil, dass der Bereich um die Öffnung bzw. Durchführung und um die Anschlussstifte vollständig gegenüber der Schaltung abgeschirmt ist. Ferner erfolgt die Abschirmung unabhängig von dem tatsächlichen Abstand zwischen Leiterplatte und Gehäuse innerhalb gegebener Toleranzen. Die Erfindung kann bei allen metallischen und bei metallisierten Gehäusen angewendet werden.

Bei der ersten Ausführungsform kann das Abschirmrohr derartig dimensioniert sein, dass es bei allen vorkommenden Abständen zwischen dem Gehäuse und der Leiterplatte einen für einen zuverlässigen Kontakt mit dem Gehäuse erforderlichen Druck ausübt.

Eine zweite Ausführungsform der Erfindung besteht darin, dass sich ein Abschirmrohr von der Leiterplatte bis zum Gehäuse erstreckt und die Öffnung und/oder die Durchführung umfasst und dass eine Einrichtung zum Längenausgleich des Abschirmrohres einen elektrischen Kontakt des Abschirmrohres unabhängig von Toleranzen zwischen der Leiterplatte und des Gehäuses dadurch bildet, dass ein am Gehäuse angeordneter umlaufender Steg und das Abschirmrohr ineinander eingreifen.

Zur sicheren Kontaktgabe und zuverlässigen Abdichtung kann bei dieser Ausführungsform vorgesehen sein, dass das Abschirmrohr mit einem als Kontaktfläche dienenden gegen den umlaufenden Steg gerichteten Bördel versehen ist.

Zu einer preiswerten Herstellung der erfindungsgemäßen Vorrichtung trägt bei, dass der umlaufende Steg einstückig mit dem Gehäuse verbunden ist. Es kann bei der Erfindung jedoch auch vorgesehen sein, dass der umlaufende Steg Teil einer Steckvorrichtung ist.

Die Erfindung läßt zahlreiche Ausführungsformen zu. Mehrere davon sind schematisch in der Zeichnung anhand mehrerer Figuren dargestellt und nachfolgend beschrieben. Es zeigt:
- Fig. 1: ein Ausführungsbeispiel mit einem erfindungsgemäßen Abschirmrohr, das teilweise balgförmig ausgebildet ist,
- Fig. 2: ein Ausführungsbeispiel mit einem erfindungsgemäßen Abschirmrohr, das in einem am Gehäuse angeordneten umlaufendem Steg eingreift,
- Fig. 3: eine Draufsicht eines erfindungsgemäßen Ausführungsbeispiels,
- Fig. 4: eine perspektivische Darstellung eines Abschirmrohres und
- Fig. 5: ein Ausführungsbeispiel mit einem erfindungsgemäßen Abschirmrohr, das einen am Gehäuse angeordneten umlaufenden Steg umfaßt.

Gleiche Teile sind in den Figuren mit gleichen Bezugszeichen versehen.

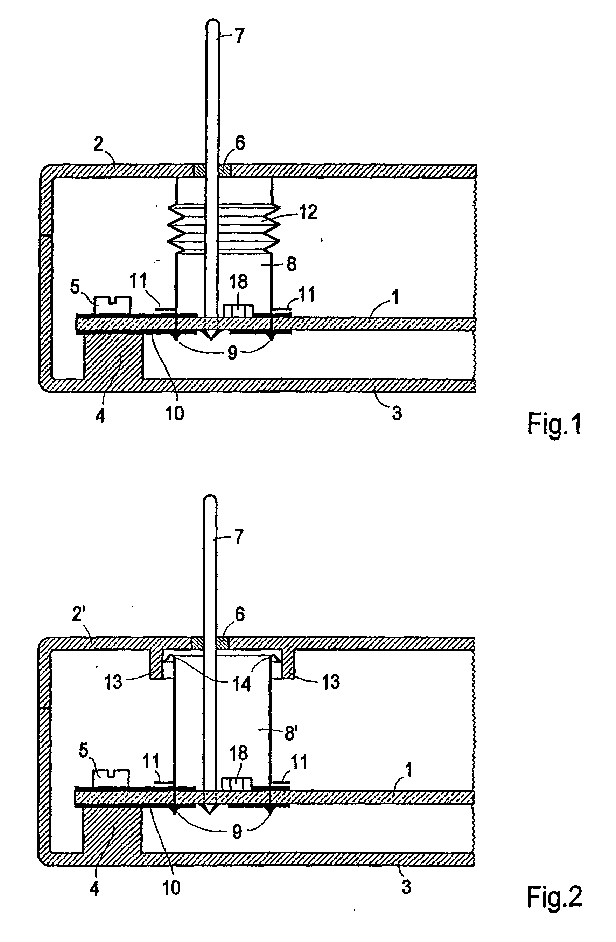

Fig. 1 stellt ein erfindungsgemäßes Ausführungsbeispiel zur Abschirmung einer auf einer Leiterplatte 1 befindlichen elektronischen Schaltung dar. Diese befindet sich in einem Gehäuse aus Metall, bestehend aus einem Gehäuse-Oberteil 2 und einem Gehäuse-Unterteil 3. Von den Befestigungen der Leiterplatte 1 sind ein Sockel 4 und eine Befestigungsschraube 5 dargestellt. Eine isolierte Durchführung 6 ermöglicht die Durchführung des Anschlußstiftes 7, welcher in die Leiterplatte eingelötet ist, durch das Gehäuse. Der Anschlußstift 7 ist mit einem Entstörkondensator 18 und der im einzelnen nicht dargestellten Schaltung verbunden. Innerhalb des Gehäuses wird der Anschlußstift 7 von dem Abschirmrohr 8 umgeben. Dieses ist mit Lötstiften 9 versehen und auf die Leiterplatte 1 aufgesteckt und mit der Masse-Leiterbahn 10 verlötet. Außerdem sind Kontaktflächen 11 als weitere Befestigungsmöglichkeit des Abschirmrohres an der Leiterplatte vorgesehen. In diesem Ausführungsbeispiel ist der obere Teil 12 des federnden Abschirmrohres 8 balgförmig ausgebildet. Zusätzlich ist ein Entstörkondensator 13 an der Leiterplattenoberfläche angebracht.

Fig. 2 zeigt ein Ausführungsbeispiel, das ebenfalls wie das nach Fig. 1 aus einem Gehäuse und einer darin befestigten Leiterplatte 1 besteht. Auch durchdringt ein Anschlußstift 7, welcher auf der Leiterplatte 1 befestigt ist, das Gehäuse-Oberteil 2'. Bei diesem Ausführungsbeispiel ist jedoch ein umlaufender Steg 13 am Gehäuse-Oberteil 2' angeordnet. Dieser umlaufende Steg 13 umfaßt das Abschirmrohr 8', dessen oberer Rand einen nach außen weisenden Bördel 14 aufweist.

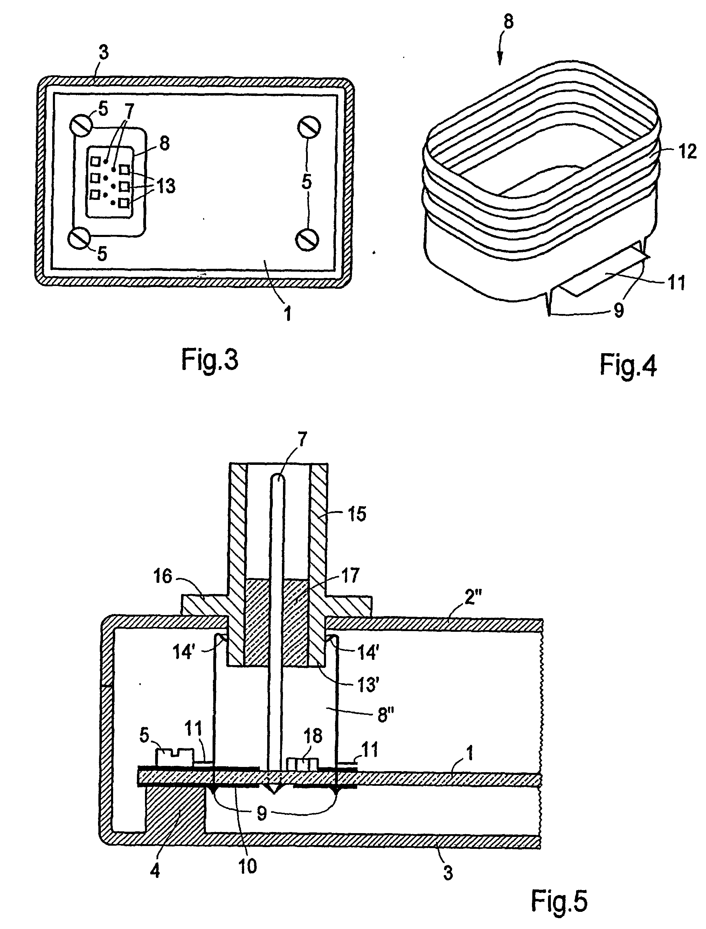

Fig. 3 zeigt eine Draufsicht durch ein weiteres Ausführungsbeispiel mit aufgeschnittenem Gehäuse. Dabei sind sechs Anschlußstifte 7 mit jeweils einem Entstörkondensator 18 vorgesehen.

Fig. 4 zeigt eine perspektivische Darstellung eines erfindungsgemäßen Abschirmrohres 8, welches bei dem in Fig. 1 beschriebenen Ausführungsbeispiel verwendet wird. Der obere Teil 12 des Abschirmrohres 8 ist balgförmig ausgebildet. Am unteren Rand des Abschirmrohres 8 sind Lötstifte 9 und Kontaktflächen 11 zur Befestigung an der Leiterplatte angebracht.

Fig. 5 zeigt ein Ausführungsbeispiel, das ebenfalls aus einem Gehäuse-Oberteil 2", einem Gehäuse-Unterteil 3 und einer daran befestigten Leiterplatte 1 besteht. Die Durchführung durch das Gehäuse-Oberteil 2" ist als Steckvorrichtung 15 ausgebildet. Das Gehäuse der Steckvorrichtung besteht neben dem eigentlich nach außen ragenden Teil aus einem Befestigungsflansch 16 und dem in den Innenraum des Gehäuses ragenden umlaufenden Steg 13'. Eine Isolierung 17 zentriert den Anschlußstift 7. Das Abschirmrohr 8" ist so ausgebildet, daß der obere Rand als Bördel 14 den umlaufenden Steg 13' umfaßt.

## Patentansprüche

1. Vorrichtung zur Abschirmung einer auf einer Leiterplatte befindlichen elektronischen Schaltung in einem elektrisch leitenden Gehäuse, das mindestens eine Öffnung und/oder Durchführung für ein Anschlußstift aufweist, welcher mit der Leiterplatte verbunden ist **dadurch gekennzeichnet, dass** sich ein auf die Leiterplatte aufgestrecktes Abschirmrohr (8) von der Leiterplatte (1) bis zum Gehäuse (2) erstreckt und den Anschlußstift umgibt und dass eine Einrichtung (12) zum Längenausgleich des Abschirmrohres (8) einen elektrischen Kontakt des Abschirmrohres (8) mit dem Gehäuse und mit der Leiterplatte unabhängig von dem Abstand zwischen der Leiterplatte (1) und des Gehäuses (2) innerhalb gegebener Toleranzen **dadurch** bildet, dass das Abschirmrohr (8) in Längsrichtung federnd ist.

2. Vorrichtung nach Anspruch 1, **dadurch gekennzeichnet, dass** mindestens ein Teil des Abschirmrohres (8) balgförmig ist.

3. Vorrichtung zur Abschirmung einer auf einer Leiterplatte befindlichen elektronischen Schaltung in einem elektrisch leitenden Gehäuse, das mindestens eine Öffnung und/oder Durchführung für ein Anschlußstift aufweist, welcher mit der Leiterplatte verbunden ist **dadurch gekennzeichnet, dass** sich ein auf die Leiterplatte aufgestrecktes Abschirmrohr (8', 8'') von der Leiterplatte (1) bis zum Gehäuse (2', 2'') erstreckt und den Anschlußstift umgibt und dass eine Einrichtung (13, 14, 13', 14') zum Längenausgleich des Abschirmrohres (8', 8'') einen elektrischen Kontakt des Abschirmrohres (8', 8'') mit dem Gehäuse und mit der Leiterplatte unabhängig von dem Abstand zwischen der Leiterplatte (1) und des Gehäuses (2', 2'') innerhalb gegebener Toleranzen **dadurch** bildet, dass ein am Gehäuse (2', 2") angeordneter umlaufender Steg (13, 13') und das Abschirmrohr (8', 8") ineinander eingreifen.

4. Vorrichtung nach Anspruch 3, **dadurch gekennzeichnet, dass** das Abschirmrohr (8', 8") mit einem als Kontaktfläche dienenden gegen den umlaufenden Steg (13, 13') gerichteten Bördel (14, 14') versehen ist.

5. Vorrichtung nach einem der Ansprüche 3 oder 4, **dadurch gekennzeichnet, dass** der umlaufende Steg (13, 13') einstückig mit dem Gehäuse (2') verbunden ist.

6. Vorrichtung nach einem der Ansprüche 3 bis 5, **dadurch gekennzeichnet, dass** der umlaufende Steg (13') Teil einer Steckvorrichtung (15) ist.

## Claims

1. Apparatus for shielding an electronic circuit situated on a printed circuit board in an electrically conductive housing which has at least one opening and/or bushing for a connection pin which is connected to the printed circuit board, **characterized in that** a shielding tube (8) stretched over the printed circuit board extends from the printed circuit board (1) as far as the housing (2) and surrounds the connection pin, and **in that** a device (12) for length equalization of the shielding tube (8) forms an electrical contact of the shielding tube (8) with the housing and with the printed circuit board independently of the distance between the printed circuit board (1) and the housing (2) within given tolerances, **in that** the shielding tube (8) is resilient in the longitudinal direction.

2. Apparatus according to Claim 1, **characterized in that** at least part of the shielding tube (8) is in bellows form.

3. Apparatus for shielding an electronic circuit situated on a printed circuit board in an electrically conductive housing which has at least one opening and/or bushing for a connection pin which is connected to the printed circuit board, **characterized in that** a shielding tube (8', 8") stretched over the printed circuit board extends from the printed circuit board (1) as far as the housing (2', 2") and surrounds the connection pin, and **in that** a device (13, 14, 13', 14') for length equalization of the shielding tube (8', 8") forms an electrical contact of the shielding tube (8', 8") with the housing and with the printed circuit board independently of the distance between the printed circuit board (1) and the housing (2', 2") within given tolerances, **in that** a peripheral web (13, 13') arranged on the housing (2', 2") and the shielding tube (8', 8") engage in one another.

4. Apparatus according to Claim 3, **characterized in that** the shielding tube (8', 8") is provided with a flange (14, 14'), which serves as contact area and is directed toward the peripheral web (13, 13').

5. Apparatus according to one of Claims 3 or 4, **characterized in that** the peripheral web (13, 13') is connected in one piece to the housing (2').

6. Apparatus according to one of Claims 3 to 5, **characterized in that** the peripheral web (13') is part of a plug apparatus (15).

## Revendications

1. Dispositif de blindage électromagnétique d'un circuit électronique se trouvant sur une carte à circuits imprimés dans un boîtier conduisant l'électricité comportant au moins une ouverture et / ou une traversée pour une broche de raccordement, laquelle est reliée à la carte à circuits imprimés, **caractérisé par le fait qu'**un tube de blindage (8) enfiché sur la carte à circuits imprimés s'étend de la carte à circuits imprimés (1) jusqu'au boîtier (2) et entoure la broche de raccordement et qu'un dispositif (12) de compensation de la longueur du tube de blindage (8) établit, dans les limites de tolérances données, indépendamment de la distance entre la carte à circuits imprimés (1) et le boîtier (2), un contact électrique du tube de blindage (8) avec le boîtier et avec la carte à circuits imprimés **par le fait que** le tube de blindage (8) est élastique dans le sens longitudinal.

2. Dispositif selon la revendication 1 **caractérisé par le fait que** au moins une partie du tube de blindage (8) est en forme de soufflet.

3. Dispositif de blindage électromagnétique d'un circuit électronique se trouvant sur une carte à circuits imprimés dans un boîtier conduisant l'électricité comportant au moins une ouverture et / ou une traversée pour une broche de raccordement, laquelle est reliée à la carte à circuits imprimés, **caractérisé par le fait qu'**un tube de blindage (8', 8") enfiché sur la carte à circuits imprimés s'étend de la carte à circuits imprimés (1) jusqu'au boîtier (2', 2") et entoure la broche de raccordement et qu'un dispositif (13, 14, 13', 14') de compensation de la longueur du tube de blindage (8', 8") établit, dans les limites de tolérances données, indépendamment de la distance entre la carte à circuits imprimés (1) et le boîtier (2', 2"), un contact électrique du tube de blindage (8', 8") avec le boîtier et avec la carte à circuits imprimés **par le fait qu'**un collet périphérique (13, 13") disposé sur le boîtier (2', 2") et le tube de blindage (8', 8") s'engagent l'un dans l'autre.

4. Dispositif selon la revendication 3 **caractérisé par le fait que** le tube de blindage (8', 8") est muni d'une bordure (14, 14') dirigée vers le collet périphérique (13, 13') et servant de surface de contact.

5. Dispositif selon l'une des revendications 3 ou 4 **caractérisé par le fait que** le collet périphérique (13, 13') est lié au boîtier (2') en formant une seule pièce.

6. Dispositif selon l'une des revendications 3 à 5 **caractérisé par le fait que** le collet périphérique (13, 13') fait partie d'un dispositif enfichable (15).
